# EUROPEAN PATENT SPECIFICATION

(11) **EP 3 422 028 B1**
(45) Date of publication and mention of the grant of the patent: **13.05.2020**
(21) Application number: 17880772.3
(22) Date of filing: 12.12.2017
(51) Int. Cl.: G01R 31/07, G01R 31/00, G07C 5/08

(54) **VEHICLE HAVING A DIAGNOSTIC SYSTEM FOR AN ELECTRICAL FUSE**
FAHRZEUG WELCHES EIN DIAGNOSTISCHES SYSTEM FÜR EINE ELEKTRISCHE SICHERUNG AUFWEIST
VÉHICULE AYANT UN SYSTÈME DE DIAGNOSTIC POUR UN FUSIBLE ÉLECTRIQUE

(30) Priority: 12.12.2016 US 201615375463
(43) Date of publication of application: 02.01.2019
(73) Proprietor: LG Chem, Ltd., Seoul 07336 (KR)
(72) Inventor: SMITH, Alexander J., Mountain View, California 94040 (US)
(74) Representative: Plasseraud IP
(86) International application number: PCT/KR2017/014560
(87) International publication number: WO 2018/110943

(56) References cited:
- DE-A1-102007 054 297
- FR-A1- 2 730 814
- JP-A- S63 131 426
- JP-A- 2010 160 026
- JP-A- 2014 187 807
- JP-A- 2016 124 512
- JP-A- 2016 124 512
- KR-B1- 101 547 597
- US-A- 6 008 627
- US-A1- 2005 254 189

## Description

### TECHNICAL FIELD

The present disclosure relates to a vehicle having a diagnostic system for an electrical fuse.

### BACKGROUND

An electrical fuse is a kind of automatic breaker, used for preventing an overcurrent from continuously flowing on a wire. For example, the electrical fuse is operated to be melted by the heat generated due to the overcurrent flowing on the wire to cut the wire.

Generally, the resistance of the electrical fuse is lowest at the beginning of life and gradually increases according to aging to become highest at the end of life. Thus, the electrical fuse should be operated to cut the connection of the wire when an overcurrent flows based on the resistance at the end of life.

However, due to repeated charging/discharging of large current or long-term use, when the electrical fuse is aged, the resistance of the electrical fuse may increase over the resistance at the end of life, which is called a degrading phenomenon. If the electrical fuse is degraded, the fuse itself may be broken due to an instant temperature rise, which may lead to explosion or firing sometimes.

The degrading phenomenon of the electrical fuse is mostly generated in a gradual way and thus cannot be easily diagnosed. Thus, in the related art, a technique capable of accurately diagnosing the degrading phenomenon of the electrical fuse is demanded. This demand increases the complexity of the diagnosing circuit.

Further background is described in JP 2016 124512 A and JPS 63131426.

### SUMMARY

### TECHNICAL PROBLEM

The inventor herein has recognized that it would be advantageous to have a vehicle with a diagnostic system for an electrical fuse to determine when the electrical fuse has degraded operation and is close to its operational end-of-life.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### TECHNICAL SOLUTION

The present invention is according to the appended claims and is as follows.

A vehicle having a diagnostic system for an electrical fuse in accordance with an exemplary embodiment is provided. The electrical fuse is electrically coupled between a battery and an electrical load.

The vehicle includes a first voltage sensor that generates a first signal indicating a first voltage level at a first end of the electrical fuse.

The vehicle further includes a second voltage sensor that generates a second signal indicating a second voltage level at a second end of the electrical fuse.

The vehicle further includes a current sensor generating a third signal indicating an amount of electrical current flowing through the electrical fuse.

The vehicle further includes a microcontroller operably coupled to the first voltage sensor, the second voltage sensor, and the current sensor.

The microcontroller has a memory device that stores a first table therein. The first table has a plurality of resistance values and a plurality of current values associated with the electrical fuse.

The microcontroller determines first and second voltage values based on the first and second signals, respectively.

The microcontroller determines a current value based on the third signal.

The microcontroller determines a first resistance value of the electrical fuse utilizing the first voltage value, the second voltage value, and the current value.

The microcontroller retrieves a first stored resistance value from the plurality of resistance values in the first table, utilizing the current value as an index to the first table.

The microcontroller multiplies the first stored resistance value by a first value to obtain an end-of-life resistance value. The microcontroller generates a first diagnostic signal indicating degraded operation of the electrical fuse if the first resistance value is greater than or equal to the end-of-life resistance value.

The plurality of resistance values in the first table correspond to beginning-of-life resistance values for the electrical fuse.

In addition, the electrical fuse may be a high-current slow-blow electrical fuse.

In addition, the vehicle having a diagnostic system for an electrical fuse in accordance with an exemplary embodiment may further comprise a vehicle controller operably communicating with the microcontroller, the vehicle controller receiving the first diagnostic signal and generating a fuse servicing message that is displayed on a vehicle display device in response to the first diagnostic signal.

In addition, the microcontroller may determine the first resistance value of the electrical fuse and generate the first diagnostic signal as described above only if the current value is greater than a threshold current value.

A vehicle having a diagnostic system for an electrical fuse in accordance with another exemplary embodiment is provided. The electrical fuse is electrically coupled between a battery and an electrical load.

The vehicle includes a first voltage sensor that generates a first signal indicating a first voltage level at a first end of the electrical fuse.

The vehicle further includes a second voltage sensor that generates a second signal indicating a second voltage level at a second end of the electrical fuse.

The vehicle further includes a current sensor generating a third signal indicating an amount of electrical current flowing through the electrical fuse.

The vehicle further includes a microcontroller operably coupled to the first voltage sensor, the second voltage sensor, and the current sensor.

The microcontroller has a memory device that stores a first table therein. The first table has a plurality of resistance values and a plurality of current values associated with the electrical fuse.

The microcontroller determines first and second voltage values based on the first and second signals, respectively.

The microcontroller determines a current value based on the third signal.

The microcontroller determines a first resistance value of the electrical fuse utilizing the first voltage value, the second voltage value, and the current value.

The microcontroller retrieves a first stored resistance value from the plurality of resistance values in the first table, utilizing the current value as an index to the first table.

The microcontroller generates a first diagnostic signal indicating degraded operation of the electrical fuse if the first resistance value is greater than or equal to the first stored resistance value.

The plurality of resistance values in the first table correspond to end-of-life resistance values for the electrical fuse.

In addition, the electrical fuse may be a high-current slow-blow electrical fuse.

In addition, the vehicle having a diagnostic system for an electrical fuse in accordance with an exemplary embodiment may further comprise a vehicle controller operably communicating with the microcontroller, the vehicle controller receiving the first diagnostic signal and generating a fuse servicing message that is displayed on a vehicle display device in response to the first diagnostic signal.

In addition, the microcontroller may determine the first resistance value of the electrical fuse only if the current value is greater than a threshold current value.

### ADVANTAGEOUS EFFECTS

According to at least one exemplary embodiment of the present invention, it is possible to diagnose a degraded operation of the electrical fuse by using a stored beginning-of-life resistance of the electrical fuse and a resistance calculated with a multiplier value.

In addition, according to at least one exemplary embodiment of the present invention, it is possible to diagnose a degraded operation of the electrical fuse by using the stored end-of-life resistance of the electrical fuse and a calculated resistance with a multiplier value.

The effects of the present invention are not limited to the above, and other effects not mentioned herein may be clearly understood from the appended claims by those having ordinary skill in the art.

### BRIEF DESCRIPTION OF THE DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a schematic of a vehicle having a diagnostic system for an electrical fuse in accordance with an exemplary embodiment;
FIG. 2 is a schematic of a first table stored in a memory device of a microcontroller utilized in the diagnostic system of FIG. 1;
FIGS. 3-4 are flowcharts of a method for determining degraded operation of an electrical fuse in accordance with an exemplary embodiment;
FIG. 5 is a schematic of a second table stored in the memory device of the microcontroller utilized in the diagnostic system of FIG. 1; and
FIGS. 6-7 are flowcharts of a method for determining degraded operation of an electrical fuse in accordance with another exemplary embodiment.

### DETAILED DESCRIPTION

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

In addition, in the present disclosure, if it is judged that detailed explanation on a known technique or configuration may unnecessarily make the essence of the present disclosure vague, the detailed explanation will be omitted.

Throughout the specification, when a portion is referred to as "comprising" or "including" any element, it means that the portion may include other elements further, not excluding other elements unless specifically stated otherwise. Furthermore, the term "control unit" described in the specification refers to a unit that processes at least one function or operation, and may be implemented by hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

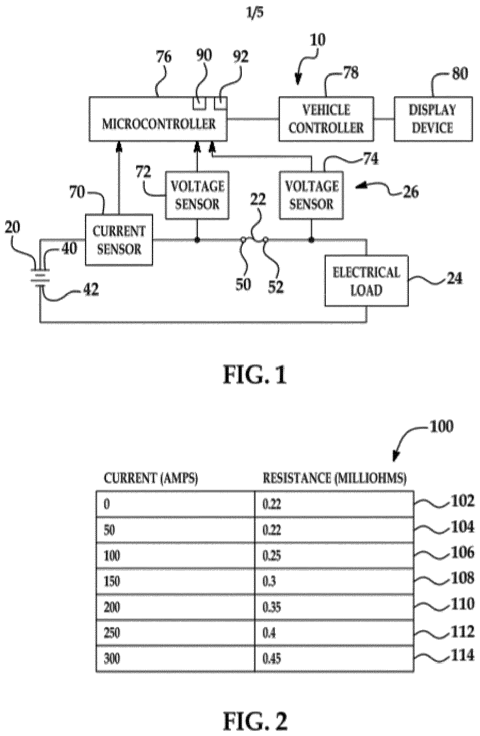

Referring to FIG. 1, a vehicle 10 according to an embodiment of the present disclosure is provided. The vehicle 10 includes a battery 20, an electrical fuse 22, an electrical load 24, and a diagnostic system 26 for the electrical fuse 22.

An advantage of the diagnostic system 26 is that the diagnostic system 26 utilizes either stored beginning-of-life resistance values with a multiplier value, or stored end-of-life resistance values of the electrical fuse 22 and a calculated resistance value, to determine whether the electrical fuse has degraded operation.

The battery 20 is provided to supply an operational voltage to the electrical load 24. The battery 20 includes a positive terminal 40 in a negative terminal 42. The positive terminal 40 is electrically coupled to the current sensor 70. The negative terminal 42 is electrically coupled to a second end of the electrical load 24. In an exemplary embodiment, the battery 20 is a lithium-ion pouch battery.

The electrical fuse 22 is electrically coupled in series between the current sensor 70 and a first end of the electrical load 24. The electrical fuse 22 includes a first end 50 and a second end 52. In an exemplary embodiment, the electrical fuse 22 is a high-current slow-blow electrical fuse. Of course, other types of electrical fuses could be utilized.

The electrical load 24 receives an electrical current from the battery 20 via the electrical fuse 22 when the electrical fuse 22 is not blown (e.g., conducts an electrical current therethrough).

Referring to FIG. 1, the diagnostic system 26 is provided to determine when the electrical fuse 22 has degraded operation. The diagnostic system 26 includes a current sensor 70, a voltage sensor 72, a voltage sensor 74, a microcontroller 76, a vehicle controller 78, and a display device 80.

The current sensor 70 is electrically coupled in series with the battery 20 and the electrical fuse 22. In particular, the current sensor 70 is electrically coupled in series between the positive terminal 40 of the battery 20 and the first end 50 of the electrical fuse 22. The current sensor 70 generates a signal indicating an amount of electrical current flowing through the electrical fuse 22, which is received by the microcontroller 76.

The voltage sensor 72 is electrically coupled to the first end 50 of the electrical fuse 22. The voltage sensor 72 generates a signal indicating a first voltage level at the first end 50 of the electrical fuse 22, which is received by the microcontroller 76.

The voltage sensor 74 is electrically coupled to the second end 52 of the electrical fuse 22. The voltage sensor 74 generates a signal indicating a second voltage level at the second end 52 of the electrical fuse 22, which is received by the microcontroller 76.

The microcontroller 76 includes a microprocessor 90 and a memory device 92. The microcontroller 76 is programmed to perform at least a portion of the steps described herein, and executes software instructions stored in the memory device 92 to perform the associated steps. The microcontroller 76 operably communicates with the current sensor 70, the voltage sensor 72, the voltage sensor 74, the memory device 92, and the vehicle controller 78.

Referring to FIGS. 1 and 2, the memory device 92 has an exemplary table 100 stored therein having beginning-of-life resistance values associated with the electrical fuse 22---which is used to determine degradation of the electrical fuse 22. The table 100 includes records 102, 104, 106, 108, 110, 112, 114 therein. Each record has: (i) an electrical current value, and (ii) a beginning-of-life resistance value of the electrical fuse 22 that is associated with the electrical current value. In particular, the plurality of records 102, 104, 106, 108, 110, 112, 114 may be set such that the beginning-of-life resistance also increases as the electrical current value increases, except for the electrical current value less than 50 amps. In other words, as the amount of electrical current flowing through the electrical fuse 22 increases, the beginning-of-life resistance may increase.

For example, referring to record 104, the record has an electrical current value of 50 amps and a beginning-of-life resistance value of 0.22 milliohms. Thus, during operation, when the electrical fuse 22 has 50 amps of electrical current flowing therethrough, the electrical fuse 22 should have a resistance that is less than a threshold resistance value (e.g., a first value * 0.22 milliohms) if the fuse 22 is not degraded. However, when the electrical fuse 22 has 50 amps of electrical current flowing therethrough and the measured resistance of the electrical fuse 22 is greater than or equal to the threshold resistance value (e.g., a first value * 0.22 milliohms), the electrical fuse 22 has degraded operation. Here, the threshold resistance value may be the end-of-life resistance. In other words, the end-of-life resistance may be obtained by multiplying the beginning-of-life resistance by the first value.

The first value corresponds to a multiplier value, and the first value may be set to gradually decrease as the electrical current value of the table 100 is greater. In other words, as the amount of electrical current flowing through the electrical fuse 22 increases, the first value may be decreased. In this case, as the amount of electrical current flowing through the electrical fuse 22 increases, the sensitivity for diagnosing the degradation of the electrical fuse 22 increases. Here, the first value may be set for each electrical current value and recorded in the memory device 92 in advance.

For example, seeing the plurality of records 106, 112, the record 106 has an electrical current value of 100 amps and a beginning-of-life resistance value of 0.25 milliohms. In addition, the record 112 has an electrical current value of 250 amps and a beginning-of-life resistance value of 0.4 milliohms. Here, in case of the record 106 having an electrical current value of 100 amps, the first value may be set to be 1.40. In addition, in case of the record 112 having an electrical current value of 250 amps, the first value may be set to be 1.25. In other words, if the amount of electrical current flowing through the electrical fuse 22 increases from 100 amps to 250 amps, the first value may be set to decrease from 1.40 to 1.25.

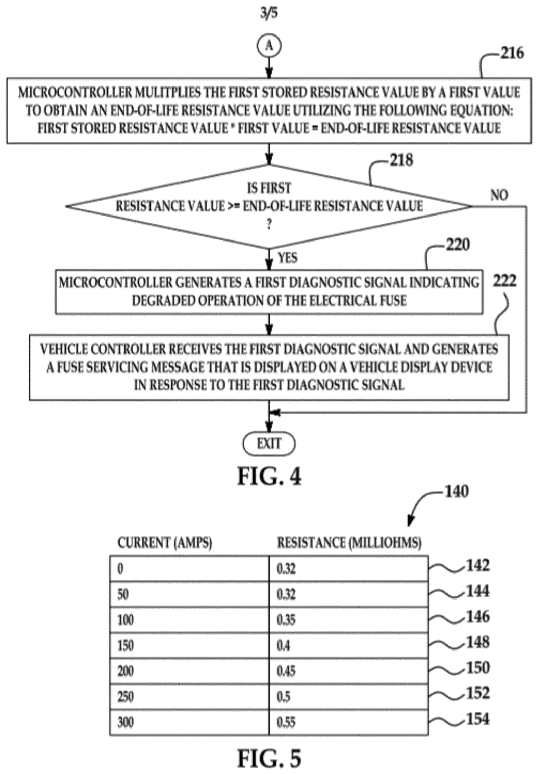

Preferably, the first value may be calculated as a ratio of the beginning-of-life resistance value and the end-of-life resistance value. In other words, the first value may be set as a ratio of the end-of-life resistance value to the beginning-of-life resistance value. For example, referring to FIGS. 2 and 5, in the plurality of records 104, 144 recorded in the plurality of tables 100, 140, if the electrical current value is 50 amps, the first value may be a ratio of 0.32 to 0.22, namely 0.32/0.22. Here, the first value may be set to satisfy the following equation.

Equation: beginning-of-life resistance value / end-of-life resistance value = first value

According to another embodiment of the present disclosure, the first value allocated to each electrical current value may decrease as the amount of entire integrated current value to the charging/discharging electrical current value increases. In this case, the microprocessor 90 may integrate electrical current values measured by the current sensor 70 to calculate an entire integrated electrical current value, and store and manage the entire integrated electrical current value in the memory device 92. The entire integrated electrical current value is not reset to 0 (zero) and is calculated from the beginning of life of the battery 20 to the end of life thereof. If the entire integrated electrical current value is great, this means that a large amount of electrical current has flowed through the electrical fuse 22. Thus, if the first value allocated to each electrical value is decreased as the entire integrated electrical current value increases, the diagnosis sensitivity of the electrical fuse 22 may be enhanced. If the electrical sensitivity is enhanced, the degrading state is diagnosed in advance before the electrical fuse 22 reaches to the end-of-life state, thereby facilitating the maintenance of the electrical fuse 22.

Referring to FIGS. 1 and 5, in an alternative embodiment, the memory device 92 has an exemplary table 140 stored therein having end-of-life resistance values associated with the electrical fuse 22---which can be used to determine degradation of the electrical fuse 22. The table 140 includes records 142, 144, 146, 148, 150, 152, 154 therein. Each record has: (i) an electrical current value, and (ii) an end-of-life resistance value associated with electrical fuse 22. In particular, the plurality of records 142, 144, 146, 148, 150, 152, 154 may be set such that the end-of-life resistance also increases as the electrical current value increases, except for the electrical current value less than 50 amps. In other words, as the amount of electrical current flowing through the electrical fuse 22 increases, the end-of-life resistance may increase.

For example, referring to record 144, the record has an electrical current value of 50 amps and an end-of-life resistance value of 0.32 milliohms. Thus, during operation, when the electrical fuse 22 has 50 amps of electrical current flowing therethrough, the electrical fuse 22 should have a resistance that is less than 0.32 milliohms if the fuse 22 is not degraded. However, when the electrical fuse 22 has 50 amps of electrical current flowing therethrough and the measured resistance of the electrical fuse 22 is greater than or equal to 0.32 milliohms, the electrical fuse 22 has degraded operation.

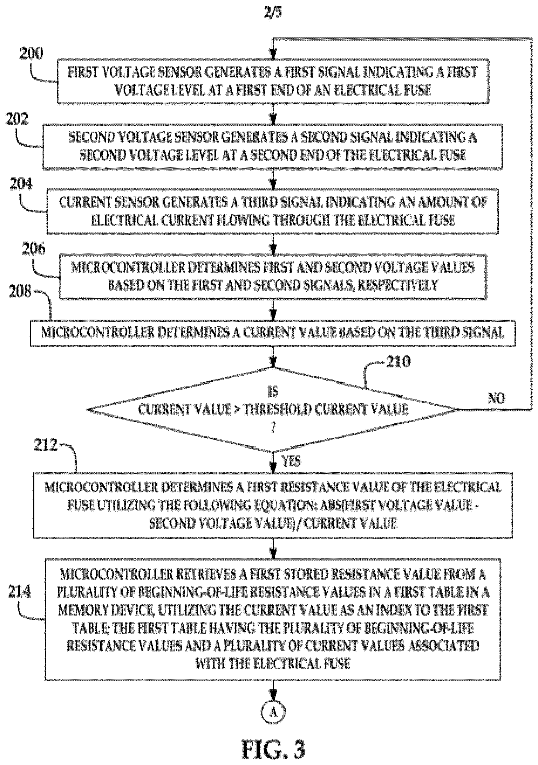

Referring to FIGS. 1-4, a flowchart of a method for determining degradation of an electrical fuse 22 utilizing stored beginning-of-life resistance values, in accordance with an exemplary embodiment is provided.

At step 200, the voltage sensor 72 generates a first signal indicating a first voltage level at the first end 50 of the electrical fuse 22. After step 200, the method advances to step 202.

At step 202, the voltage sensor 74 generates a second signal indicating a second voltage level at the second end 52 of the electrical fuse 22. After step 202, the method advances to step 204.

At step 204, the current sensor 70 generates a third signal indicating an amount of electrical current flowing through the electrical fuse 22. After step 204, the method advances to step 206.

At step 206, the microcontroller 76 determines first and second voltage values based on the first and second signals, respectively. After step 206, the method advances to step 208.

At step 208, the microcontroller 76 determines a current value based on the third signal. After step 208, the method advances to step 210.

At step 210, microcontroller 76 makes a determination as to whether the current value is greater than a threshold current value. If the value of step 210 equals "yes", the method advances to step 212. Otherwise, the method returns to step 200.

At step 212, the microcontroller 76 determines a first resistance value of the electrical fuse 22 utilizing the following equation.

Equation: Abs(first voltage value - the second voltage value) / current value

Here, Abs corresponds to an absolute value function. After step 212, the method advances step 214.

At step 214, the microcontroller 76 retrieves a first stored resistance value from a plurality ofbeginning-of-life resistance values in the table 100 in the memory device 92, utilizing the current value as an index to the table 100. The table 100 has the plurality of beginning-of-life resistance values and a plurality of current values associated with the electrical fuse 22. After step 214, the method advances to step 216.

At step 216, the microcontroller 76 multiplies the first stored resistance value by a first value to obtain an end-of-life resistance value utilizing the following equation.

Equation: first stored resistance value * first value = end-of-life resistance value.

After step 216, the method advances to step 218.

At step 218, the microcontroller 76 makes a determination as to whether the first resistance value is greater than or equal to the end-of-life resistance value. If the value of step 218 equals "yes", the method advances to step 220. Otherwise, the method is exited.

At step 220, the microcontroller 76 generates a first diagnostic signal indicating degraded operation of the electrical fuse 22. After step 220, the method advances to step 222.

At step 222, the vehicle controller 78 receives the first diagnostic signal and generates a fuse servicing message that is displayed on the vehicle display device 80 in response to the first diagnostic signal. After step 222, the method is exited.

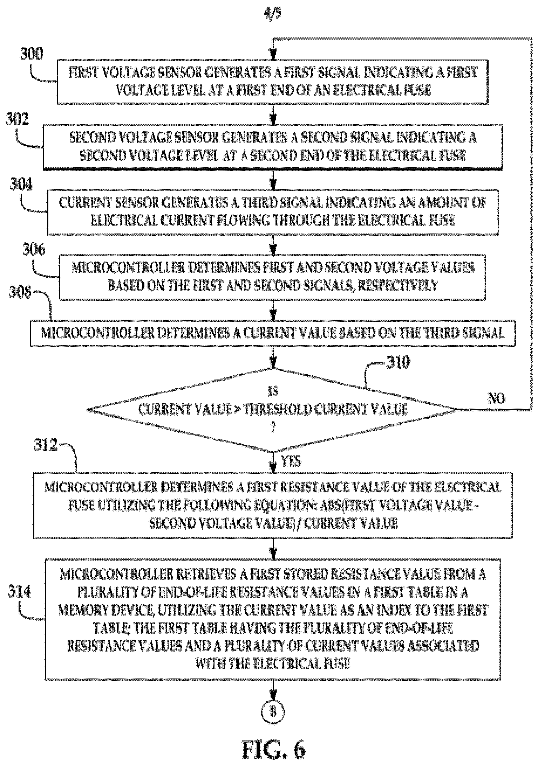

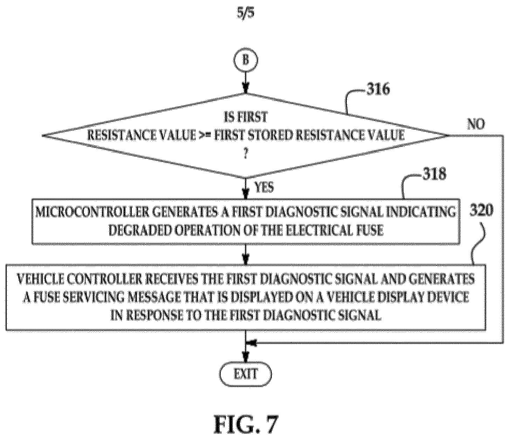

Referring to FIGS. 1 and 5-7, a flowchart of a method for determining degradation of an electrical fuse 22 utilizing stored end-of-life resistance values, in accordance with another exemplary embodiment is provided.

At step 300, the voltage sensor 72 generates a first signal indicating a first voltage level at the first end 50 of the electrical fuse 22. After step 300, the method advances to step 302.

At step 302, the voltage sensor 74 generates a second signal indicating a second voltage level at the second end 52 of the electrical fuse 22. After step 302, the method advances to step 304.

At step 304, the current sensor 70 generates a third signal indicating an amount of electrical current flowing through the electrical fuse 22. After step 304, the method advances to step 306.

At step 306, the microcontroller 76 determines first and second voltage values based on the first and second signals, respectively. After step 306, the method advances to step 308.

At step 308, the microcontroller 76 determines a current value based on the third signal. After step 308, the method advances to step 310.

At step 310, microcontroller 76 makes a determination as to whether the current value is greater than a threshold current value. If the value of step 310 equals "yes", the method advances step 312. Otherwise, the method returns to step 300.

At step 312, the microcontroller 76 determines a first resistance value of the electrical fuse 22 utilizing the following equation.

Equation: Abs(first voltage value - the second voltage value) / current value

Here, Abs corresponds to an absolute value function. After step 312, the method advances to step 314.

At step 314, the microcontroller 76 retrieves a first stored resistance value from a plurality of end-of-life resistance values in the table 140 in the memory device 92, utilizing the current value as an index to the table 140. The table 140 has the plurality of end-of-life resistance values and a plurality of current values associated with the electrical fuse 22. After step 314, the method advances to step 316.

At step 316, the microcontroller 76 makes a determination as to whether the first resistance value is greater than or equal to the first stored resistance value. If the value of step 316 equals "yes", the method advances to step 318. Otherwise, the method if exited.

At step 318, the microcontroller 76 generates a first diagnostic signal indicating degraded operation of the electrical fuse 22. After step 318, the method advances to step 320.

At step 320, the vehicle controller 78 receives the first diagnostic signal and generates a fuse servicing message that is displayed on a vehicle display device 80 in response to the first diagnostic signal. After step 320, the method is exited.

The vehicle described herein provides a substantial advantage over other vehicles. In particular, the vehicle utilizes a diagnostic system for determining degraded operation of an electrical fuse. Further, an advantage of the diagnostic system is that the diagnostic system utilizes either stored beginning-of-life resistance values with a multiplier value, or stored end-of-life resistance values of the electrical fuse, and a calculated resistance value to determine whether the electrical fuse has degraded operation.

While the claimed invention has been described in detail in connection with only a limited number of embodiments, it should be readily understood that the invention is not limited to such disclosed embodiments.

Additionally, while various embodiments of the claimed invention have been described, it is to be understood that aspects of the invention may include only some of the described embodiments. Accordingly, the claimed invention is not to be seen as limited by the foregoing description.

## Claims

1. A vehicle having a diagnostic system for an electrical fuse, comprising:
a first voltage sensor adapted to generate a first signal indicating a first voltage level at a first end of the electrical fuse;
a second voltage sensor adapted to generate a second signal indicating a second voltage level at a second end of the electrical fuse;
a current sensor adapted to generate a third signal indicating an amount of electrical current flowing through the electrical fuse;
a microcontroller that is adapted to determine first and second voltage values based on the first and second signals, respectively, and a current value based on the third signal;
the microcontroller is further adapted to determine a first resistance value of the electrical fuse utilizing the first and second voltage values and the current value;
**characterized in that**:
the microcontroller has a memory device that stores a table therein, the table having a plurality of records therein, wherein each record has an electrical current value and a beginning-of-life resistance of the electrical fuse that is associated with the electrical current value;
the microcontroller is adapted to retrieve a first stored resistance value associated with the electrical fuse from the plurality of beginning-of-life resistance values in the table, utilizing the current value as an index to the table;
the microcontroller is adapted to multiply the first stored resistance value by a first value to obtain an end-of-life resistance value; and
the microcontroller is adapted to generate a diagnostic signal indicating degraded operation of the electrical fuse if the first resistance value is greater than or equal to the end-of-life resistance value.

2. The vehicle of claim 1, wherein the electrical fuse is a high-current slow-blow electrical fuse.

3. The vehicle of claim 1, further comprising a vehicle controller configured to operably communicate with the microcontroller, the vehicle controller being adapted to receive the diagnostic signal and to generate a fuse servicing message that is displayed on a vehicle display device in response to the diagnostic signal.

4. The vehicle of claim 1, wherein the microcontroller is adapted to determine the first resistance value of the electrical fuse only if the current value is greater than a threshold current value.

5. The vehicle of any of claims 1 to 4, wherein in the table, the beginning-of-life resistance also increases as the electrical current value increases, except for the electrical current value less than 50 amps.

6. A vehicle having a diagnostic system for an electrical fuse, comprising:
a first voltage sensor adapted to generate a first signal indicating a first voltage level at a first end of the electrical fuse;
a second voltage sensor adapted to generate a second signal indicating a second voltage level at a second end of the electrical fuse;
a current sensor adapted to generate a third signal indicating an amount of electrical current flowing through the electrical fuse;
a microcontroller that is adapted to determine first and second voltage values based on the first and second signals, respectively, and a current value based on the third signal; wherein
the microcontroller is further adapted to determine a first resistance value of the electrical fuse utilizing the first and second voltage values and the current value;
**characterized in that**:
the microcontroller has a memory device that stores a table therein, the table having a plurality of records therein, wherein each record has an electrical current value and an end-of-life resistance value associated with the electrical fuse;
the microcontroller is adapted to retrieve a first stored resistance value associated with the electrical fuse from the plurality of end-of-life resistance values in the table, utilizing the current value as an index to the table; and
the microcontroller is adapted to generate a diagnostic signal indicating degraded operation of the electrical fuse if the first resistance value is greater than or equal to the first stored resistance value.

7. The vehicle of claim 6, wherein the electrical fuse is a high-current slow-blow electrical fuse.

8. The vehicle of claim 6, further comprising a vehicle controller configured to operably communicate with the microcontroller, the vehicle controller being adapted to receive the diagnostic signal and to generate a fuse servicing message that is displayed on a vehicle display device in response to the diagnostic signal.

9. The vehicle of claim 6, wherein the microcontroller is adapted to determine the first resistance value of the electrical fuse only if the current value is greater than a threshold current value.

10. The vehicle of any claim 6 to 9, wherein in the table, the end-of-life resistance also increases as the electrical current value increases, except for the electrical current value less than 50 amps.

## Patentansprüche

1. Fahrzeug, welches ein diagnostisches System für eine elektrische Sicherung aufweist, umfassend:
einen ersten Spannungssensor, welcher dazu eingerichtet ist, ein erstes Signal zu erzeugen, welches ein erstes Spannungsniveau an einem ersten Ende der elektrischen Sicherung anzeigt;
einen zweiten Spannungssensor, welcher dazu eingerichtet ist, ein zweites Signal zu erzeugen, welches ein zweites Spannungsniveau an einem zweiten Ende der elektrischen Sicherung anzeigt;
einen Stromsensor, welcher dazu eingerichtet ist, ein drittes Signal zu erzeugen, welches eine Menge von elektrischem Strom anzeigt, welcher durch die elektrische Sicherung fließt;
einen Mikrocontroller, welcher dazu eingerichtet ist, erste und zweite Spannungswerte auf Grundlage des ersten bzw. des zweiten Signals und einen Stromwert auf Grundlage des dritten Signals zu bestimmen;
wobei der Mikrocontroller ferner dazu eingerichtet ist, einen ersten Widerstandswert der elektrischen Sicherung unter Verwendung der ersten und zweiten Spannungswerte und des Stromwerts zu bestimmen;
**dadurch gekennzeichnet, dass**:
der Mikrocontroller eine Speichervorrichtung aufweist, welche eine Tabelle darin speichert, wobei die Tabelle eine Mehrzahl von Aufnahmen darin umfasst, wobei jede Aufnahme einen elektrischen Stromwert und einen Lebenszyklus-Beginn-Widerstand der elektrischen Sicherung aufweist, welcher dem elektrischen Stromwert zugeordnet ist;
der Mikrocontroller dazu eingerichtet ist, einen ersten gespeicherten Widerstandswert, welcher der elektrischen Sicherung zugeordnet ist, von der Mehrzahl von Lebenszyklus-Beginn-Widerstandswerten in der Tabelle zu erhalten, unter Verwendung des Stromwerts als einen Index für die Tabelle;
der Mikrocontroller dazu eingerichtet ist, den ersten gespeicherten Widerstandswert mit einem ersten Wert zu multiplizieren, um einen Lebenszyklus-Ende-Widerstandswert zu erhalten; und
der Mikrocontroller dazu eingerichtet ist, ein diagnostisches Signal zu erzeugen, welches einen abgeschwächten Betrieb der elektrischen Sicherung anzeigt, wenn der erste Widerstandswert größer oder gleich dem Lebenszyklus-Ende-Widerstandswert ist.

2. Fahrzeug nach Anspruch 1, wobei die elektrische Sicherung eine elektrische träge Hochstrom-Sicherung ist.

3. Fahrzeug nach Anspruch 1, ferner umfassend eine Fahrzeug-Steuereinheit, welche dazu eingerichtet ist, mit dem Mikrocontroller betriebsmäßig zu kommunizieren, wobei die Fahrzeug-Steuereinheit dazu eingerichtet ist, das diagnostische Signal zu empfangen und eine Sicherung-Wartungsnachricht zu erzeugen, welche an einer Fahrzeug-Anzeigevorrichtung in Reaktion auf das diagnostische Signal angezeigt wird.

4. Fahrzeug nach Anspruch 1, wobei der Mikrocontroller dazu eingerichtet ist, den ersten Widerstandswert der elektrischen Sicherung nur zu bestimmen, wenn der Stromwert größer ist als ein Strom-Schwellenwert.

5. Fahrzeug nach einem der Ansprüche 1 bis 4, wobei in der Tabelle der Lebenszyklus-Beginn-Widerstand auch ansteigt, wenn der elektrische Stromwert steigt, mit Ausnahme für den elektrischen Stromwert geringer als 50A.

6. Fahrzeug, welches ein diagnostisches System für eine elektrische Sicherung aufweist, umfassend:
einen ersten Spannungssensor, welcher dazu eingerichtet ist, ein erstes Signal zu erzeugen, welches ein erstes Spannungsniveau an einem ersten Ende der elektrischen Sicherung anzeigt;
einen zweiten Spannungssensor, welcher dazu eingerichtet ist, ein zweites Signal zu erzeugen, welches ein zweites Spannungsniveau an einem zweiten Ende der elektrischen Sicherung anzeigt;
einen Stromsensor, welcher dazu eingerichtet ist, ein drittes Signal zu erzeugen, welches eine Menge von elektrischem Strom anzeigt, welcher durch die elektrische Sicherung fließt;
einen Mikrocontroller, welcher dazu eingerichtet ist, erste und zweite Spannungswerte auf Grundlage des ersten bzw. des zweiten Signals und einen Stromwert auf Grundlage des dritten Signals zu bestimmen;
wobei der Mikrocontroller ferner dazu eingerichtet ist, einen ersten Widerstandswert der elektrischen Sicherung unter Verwendung der ersten und zweiten Spannungswerte und des Stromwerts zu bestimmen;
**dadurch gekennzeichnet, dass**:
der Mikrocontroller eine Speichervorrichtung aufweist, welche eine Tabelle darin speichert, wobei die Tabelle eine Mehrzahl von Aufnahmen darin umfasst, wobei jede Aufnahme einen elektrischen Stromwert und einen Lebenszyklus-Ende-Widerstand aufweist, welcher der elektrischen Sicherung zugeordnet ist;
der Mikrocontroller dazu eingerichtet ist, einen ersten gespeicherten Widerstandswert, welcher der elektrischen Sicherung zugeordnet ist, von der Mehrzahl von Lebenszyklus-Ende-Widerstandswerten in der Tabelle zu erhalten, unter Verwendung des Stromwerts als einen Index für die Tabelle; und
der Mikrocontroller dazu eingerichtet ist, ein diagnostisches Signal zu erzeugen, welches einen abgeschwächten Betrieb der elektrischen Sicherung anzeigt, wenn der erste Widerstandswert größer oder gleich dem ersten gespeicherten Widerstandswert ist.

7. Fahrzeug nach Anspruch 6, wobei die elektrische Sicherung eine elektrische träge Hochstrom-Sicherung ist.

8. Fahrzeug nach Anspruch 6, ferner umfassend eine Fahrzeug-Steuereinheit, welche dazu eingerichtet ist, mit dem Mikrocontroller betriebsmäßig zu kommunizieren, wobei die Fahrzeug-Steuereinheit dazu eingerichtet ist, das diagnostische Signal zu empfangen und eine Sicherung-Wartungsnachricht zu erzeugen, welche an einer Fahrzeug-Anzeigevorrichtung in Reaktion auf das diagnostische Signal angezeigt wird.

9. Fahrzeug nach Anspruch 6, wobei der Mikrocontroller dazu eingerichtet ist, den ersten Widerstandswert der elektrischen Sicherung nur zu bestimmen, wenn der Stromwert größer ist als ein Strom-Schwellenwert.

10. Fahrzeug nach einem der Ansprüche 6 bis 9, wobei in der Tabelle der Lebenszyklus-Ende-Widerstand auch ansteigt, wenn der elektrische Stromwert steigt, mit Ausnahme für den elektrischen Stromwert geringer als 50A.

## Revendications

1. Véhicule ayant un système de diagnostic pour un fusible électrique, comprenant :
un premier capteur de tension apte à générer un premier signal indiquant un premier niveau de tension à une première extrémité du fusible électrique ;
un second capteur de tension apte à générer un deuxième signal indiquant un second niveau de tension à une seconde extrémité du fusible électrique ;
un capteur de courant apte à générer un troisième signal indiquant une quantité de courant électrique s'écoulant à travers le fusible électrique ;
un microcontrôleur qui est apte à déterminer des première et seconde valeurs de tension sur la base respectivement des premier et deuxième signaux, et une valeur d'intensité sur la base du troisième signal ;
le microcontrôleur est en outre apte à déterminer une première valeur de résistance du fusible électrique en utilisant les première et seconde valeurs de tension et la valeur d'intensité ;
**caractérisé en ce que** :
le microcontrôleur a un dispositif de mémoire qui stocke un tableau à l'intérieur de celui-ci, le tableau ayant une pluralité d'enregistrements à l'intérieur de celui-ci, dans lequel chaque enregistrement a une valeur d'intensité électrique et une résistance de début de vie du fusible électrique qui est associée à la valeur d'intensité électrique ;
le microcontrôleur est apte à récupérer une première valeur de résistance stockée associée au fusible électrique parmi la pluralité de valeurs de résistance de début de vie dans le tableau, en utilisant la valeur d'intensité en tant qu'indice dans le tableau ;
le microcontrôleur est apte à multiplier la première valeur de résistance stockée par une première valeur pour obtenir une valeur de résistance de fin de vie ; et
le microcontrôleur est apte à générer un signal de diagnostic indiquant un fonctionnement dégradé du fusible électrique si la première valeur de résistance est supérieure ou égale à la valeur de résistance de fin de vie.

2. Véhicule selon la revendication 1, dans lequel le fusible électrique est un fusible électrique à action retardée à haute intensité.

3. Véhicule selon la revendication 1, comprenant en outre un organe de commande de véhicule configuré pour communiquer, de manière opérationnelle, avec le microcontrôleur, l'organe de commande de véhicule étant apte à recevoir le signal de diagnostic et à générer un message d'entretien de fusible qui est affiché sur un dispositif d'affichage de véhicule en réponse au signal de diagnostic.

4. Véhicule selon la revendication 1, dans lequel le microcontrôleur est apte à déterminer la première valeur de résistance du fusible électrique uniquement si la valeur d'intensité est supérieure à une valeur d'intensité de seuil.

5. Véhicule selon l'une quelconque des revendications 1 à 4, dans lequel, dans le tableau, la résistance de début de vie augmente également au fur et à mesure de l'augmentation de la valeur d'intensité électrique, sauf si la valeur d'intensité électrique est inférieure à 50 A.

6. Véhicule ayant un système de diagnostic pour un fusible électrique, comprenant :
un premier capteur de tension apte à générer un premier signal indiquant un premier niveau de tension à une première extrémité du fusible électrique ;
un second capteur de tension apte à générer un deuxième signal indiquant un second niveau de tension à une seconde extrémité du fusible électrique ;
un capteur de courant apte à générer un troisième signal indiquant une quantité de courant électrique s'écoulant à travers le fusible électrique ;
un microcontrôleur qui est apte à déterminer des première et seconde valeurs de tension sur la base respectivement des premier et deuxième signaux, et une valeur d'intensité sur la base du troisième signal ;
dans lequel le microcontrôleur est en outre apte à déterminer une première valeur de résistance du fusible électrique en utilisant les première et seconde valeurs de tension et la valeur d'intensité ;
**caractérisé en ce que** :
le microcontrôleur a un dispositif de mémoire qui stocke un tableau à l'intérieur de celui-ci, le tableau ayant une pluralité d'enregistrements à l'intérieur de celui-ci, dans lequel chaque enregistrement a une valeur d'intensité électrique et une valeur de résistance de fin de vie qui est associée au fusible électrique ;
le microcontrôleur est apte à récupérer une première valeur de résistance stockée associée au fusible électrique parmi la pluralité de valeurs de résistance de fin de vie dans le tableau, en utilisant la valeur d'intensité en tant qu'indice dans le tableau ; et
le microcontrôleur est apte à générer un signal de diagnostic indiquant un fonctionnement dégradé du fusible électrique si la première valeur de résistance est supérieure ou égale à la première valeur de résistance stockée.

7. Véhicule selon la revendication 6, dans lequel le fusible électrique est un fusible électrique à action retardée à haute intensité.

8. Véhicule selon la revendication 6, comprenant en outre un organe de commande de véhicule configuré pour communiquer, de manière opérationnelle, avec le microcontrôleur, l'organe de commande de véhicule étant apte à recevoir le signal de diagnostic et à générer un message d'entretien de fusible qui est affiché sur un dispositif d'affichage de véhicule en réponse au signal de diagnostic.

9. Véhicule selon la revendication 6, dans lequel le microcontrôleur est apte à déterminer la première valeur de résistance du fusible électrique uniquement si la valeur d'intensité est supérieure à une valeur d'intensité de seuil.

10. Véhicule selon l'une quelconque des revendications 6 à 9, dans lequel, dans le tableau, la résistance de fin de vie augmente également au fur et à mesure de l'augmentation de la valeur d'intensité électrique, sauf si la valeur d'intensité électrique est inférieure à 50 A.
